# FASCICULE DE BREVET EUROPEEN

(11) **EP 0 559 574 B1**
(45) Date de publication et mention de la délivrance du brevet: **11.09.1996**
(21) Numéro de dépôt: 93400575.2
(22) Date de dépôt: 05.03.1993
(51) Int. Cl.: C04B 35/00, C01G 3/00, H01L 39/24, C04B 35/64

(54) **Procédé de préparation d'une poudre d'YBaCuO (phase 123) en vue d'une mise en forme par étirage-laminage**
Verfahren zur Herstellung eines Yttrium-Barium-Kupfer-Oxid-Pulvers (123 Typ) zur Formgebung durch Streckung-Laminierung
Process for the preparation of an yttrium-barium-copper-oxide powder (123 phase) for shaping by drawing-laminating

(30) Priorité: 06.03.1992 FR 9202726
(43) Date de publication de la demande: 08.09.1993
(73) Titulaire: ALCATEL ALSTHOM COMPAGNIE GENERALE D'ELECTRICITE, F-75008 Paris (FR)
(72) Inventeur: Duperray, Gérard, F-91290 La Norville (FR); Audry, Claudette, F-91300 Massy (FR); Ducatel, Francoise, F-78830 Bonnelles (FR)
(74) Mandataire: Laroche, Danièle

(56) Documents cités:
- EP-A- 0 309 322
- EP-A- 0 316 741
- EP-A- 0 326 944
- EP-A- 0 376 276
- WO-A-88/10235

## Description

La présente invention concerne un procédé de préparation d'une poudre d'YBaCuO (phase 123) en vue d'une mise en forme par étirage-laminage.

Le fait que les nouveaux supraconducteurs, dits à haute température critique, soient des céramiques constitue un gros handicap car leur mise en oeuvre est bien plus délicate que celle des supraconducteurs métalliques à basse température critique. Le problème se pose particulièrement pour la réalisation de conducteurs souples tels que des fils et des câbles multifilamentaires.

Une famille parmi ces nouveaux composés présente néanmoins une ductilité qui, sans atteindre celle des métaux, permet, par la méthode dite de "poudre dans tube métallique", de réaliser des fils par étirage ou des rubans par laminage; il s'agit des composés (Bi₂₋ₓPbₓ)₂ Sr₂CaₙCuₙ₊₁ 0₂ₙ₊₆ (avec O ≦ n ≦ 2), pour lesquels cette "ductilité" constitue un intérêt majeur.

Par contre le composé Y₁Ba₂Cu₃0₇ appelé dans toute la suite Y123, qui a par ailleurs de sérieux avantages sur les autres, présente généralement le caractère dur et cassant propre aux céramiques, comme le déplorent bon nombre d'auteurs dans les publications suivantes:
(1) R.FLUCKIGER : VI Int^{al} Workshop on Critical Currents 8/11 july 91 Cambridge U.K.
(2) T. NISHIO et al : Journal of Materials Science Vol 24 (1989) p. 3228-34
(3) D.F.LEE; K.SALAMA : Physica C 181 (1991) 81-87
(4) S. JIN et al : Materials Science and Engineering B7 (1991) 243-260.

Parmi les brevets décrivant des procédés de fabrication de Y123 qui ne donnent pas satisfaction, on peut citer EP-A-326 944 et WO-A-88/10235. EP-A-326 944 prévoit une atomisation d'une barbotine pour former des agglomérats, un passage à la flamme des agglomérats pour former une poudre intermédiaire, et un recuit de cette dernière pour former une masse friable.

WO-A-88/10235 indique la préparation d'une solution de nitrates des précurseurs à laquelle est ajouté de l'acide oxalique ; le précipité obtenu est séché par atomisation puis soumis à un traitement thermique.

La présente invention a pour but de préparer une poudre Y123 dont la morphologie soit telle qu'elle ait une aptitude au fluage proche de celle des phases supraconductrices au bismuth et qui soit tout à fait adaptée à une mise en forme par étirage-laminage.

La présente invention a pour objet un procédé de préparation d'une poudre d'YBaCuO (phase 123) en vue d'une mise en forme par étirage-laminage, procédé selon lequel:
- on prépare un mélange réactionnel poudreux de précurseurs de pureté supérieure à 99% et dont la stoechiométrie est exacte à moins de 1%,
- on agglomère ce mélange réactionnel poudreux pour en faire des pièces intermédiaires d'épaisseur inférieure à deux millimètres que l'on introduit dans un four en limitant au maximum leur contact avec un support,
- on effectue un traitement thermique comportant au moins les étapes suivantes:
   . un premier palier de durée comprise entre 10 et 30 heures à une température T₁ comprise entre 890°C et 910°C sous une atmosphère à 20% d'oxygène, correspondant à la synthèse de la phase Y123 quadratique,
   . un second palier de durée comprise entre 20 et 100 heures à une température T₂ comprise entre 920°C et 960°C sous une atmosphère à 20% d'oxygène, correspondant à la recristallisation de la phase quadratique Y123,
   . un troisième palier de durée comprise entre 10 et 50 heures à une température T₃ comprise entre 500°C et 300°C sous oxygène pur, correspondant à la transformation de la phase Y123 quadratique en phase Y123 orthorhombique,
- on effectue un broyage à sec jusqu'à obtenir des grains de diamètre moyen de l'ordre de quelques µm formant ladite poudre.

Les valeurs de T₁ et T₂, données précédemment pour une atmosphère de 20% d'oxygène, doivent être abaissées de 10°C à 20°C lorsque cette atmosphère contient 10% d'oxgène; elles doivent être élevées d'autant, lorsque l'atmosphère contient 30% d'oxygène. La fourchette pratique de pression partielle d'oxygène est de 5 à 30% durant la partie du traitement thermique où la température est supérieure à T₁; cette valeur peut être augmentée jusqu'à 100% durant la partie du traitement thermique où la température est inférieure à T₁.

Ledit traitement thermique peut être détaillé de la manière suivante:
- montée rapide jusqu'à 800°C
- montée lente jusqu'à T₁
- premier palier de 10 à 3O heures à T₁
- montée lente jusqu'à T₂
- second palier de 20 à 100 heures à T₂ (d'autant plus long que T₂ est plus basse)
- descente moyenne jusqu'à 600°C
- descente lente jusqu'à T₃
- troisième palier de 10 à 50 heures à T₃ (d'autant plus long que l'épaisseur desdites pièces intermédiaires est plus grande)
- descente moyenne jusqu'à 250°C
- descente rapide jusqu'à 25°C,
Avec :
- montée ou descente rapide : 120 à 60°C/heure
- montée ou descente moyenne : 60 à 40°C/heure
- montée ou descente lente : 40 à 20°C/heure.

Selon un premier mode de réalisation ledit mélange réactionnel de précurseurs est un mélange poudreux activé par broyage de précurseurs élémentaires Y₂O₃, BaCO₃, CuO.

Selon un second mode de réalisation ledit mélange réactionnel de précurseurs est obtenu par coprécipitation, puis filtré et séché.

Selon un troisième mode de réalisation ledit mélange réactionnel est constitué de précurseurs obtenus par calcination d'un aérosol de nitrates d'yttrium, de baryum et de cuivre en solution dans l'eau.

Dans tous les modes de réalisation il est obligatoire que la stoechiométrie soit la plus exacte possible.

Lesdites pièces intermédiaires peuvent être avantageusement des tubes empilés en pyramide, des plaques ou des pastilles empilées les unes sur les autres, et séparées par des cales; elles peuvent définir une structure alvéolaire en nid d'abeille.

Grâce à de telles dispositions et au fait que les zones de contact des pièces intermédiaires avec un support quelconque dans le four soient réduites au maximum, il y a peu de risque d'absorption par ce support de la phase liquide apparaissant au cours du traitement thermique et qui a généralement la composition Ba₃Cu₅O₈. Toute fraction de phase liquide manquante ferait en effet défaut à la masse réactionnelle et il en résulterait un produit final pollué par des composés parasites tels que Y₂BaCu0₅.

La préservation de la totalité de la phase liquide de la masse réactionnelle a également pour effet de favoriser le grossissement des grains de Y123 sous la forme quadratique.

Le grossissement de ces grains est optimisé en outre par le choix de la température T₂ comprise entre 920°C et 960°C sous une atmosphère à 20% d'oxygène. La durée de ce second palier de cristallisation des grains n'est limitée que par des considérations économiques et par des phénomènes lents tels que la sublimation de CuO; des durées de 20 heures à 100 heures semblent être des limites pratiques.

Au terme de ce second palier, la porosité résiduelle des pièces intermédiaires précédemment définies est de l'ordre de 10 à 15%, ce qui correspond à une densité de 5,8 à 5,5. Ces pièces intermédiaires présentant une forme à grand rapport surface/volume, le parcours de diffusion de l'oxygène se trouve limité uniformément au cours du troisième palier du traitement thermique permettant la transformation des cristaux de Y123 quadratique, en cristaux de Y123 orthorhombique. On aboutit donc à la fin de cette transformation à une homogénéité des pièces intermédiaires qui présentent suivant toute leur épaisseur la composition Y123 orthorhombique supraconductrice, stable à basse température.

Grâce aux paramètres du procédé selon l'invention les pièces intermédiaires traitées sont homogènes à trois niveaux:
- pureté de phase: la composition Y₁Ba₂Cu₃0₇ est non seulement globale, mais locale au niveau du grain élémentaire,
- forme allotropique : tous les cristaux sont orthorhombiques en tout point,
- diamètre des grains cristallographiques: la répartition de diamètres observée sur une coupe métallographique est étroite; on peut indiquer 50 à 100 µm entre deux écarts types.

Par suite du broyage des pièces intermédiaires, les grains cristallographiques sont cassés et l'on a une poudre dont les grains ont un diamètre moyen choisi voisin de 10 µm, et en tout cas inférieur à 50 µm.

D'autres caractéristiques et avantages de la présente invention apparaîtront au cours de la description suivante de modes de réalisation donnés à titre illustratif mais nullement limitatif. Dans le dessin annexé :

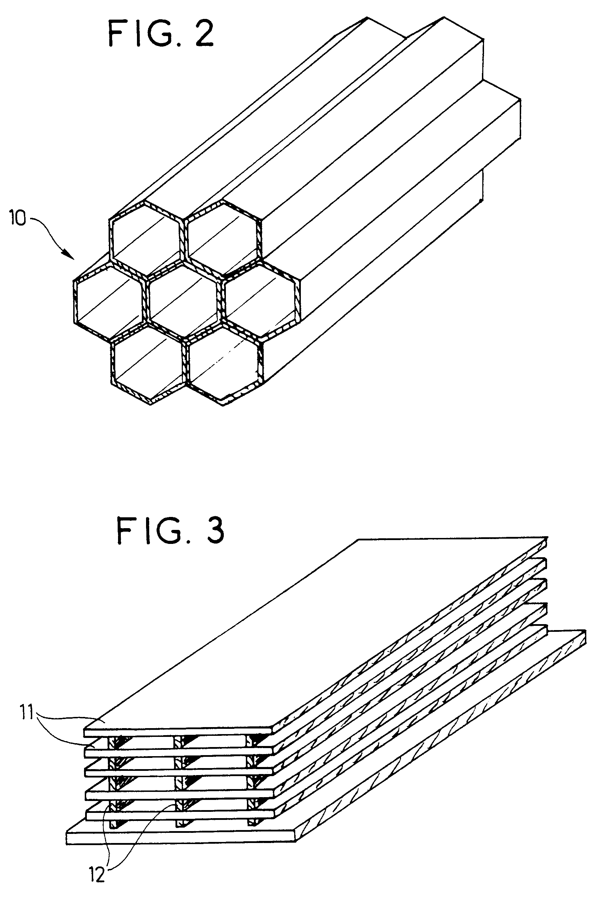

- les figures 1 à 3 montrent schématiquement en perspective diverses formes de pièces intermédiaires intervenant dans le procédé de préparation d'une poudre selon l'invention,
- la figure 4 est un diagramme de diffraction X d'une poudre selon l'invention.
- la figure 5 est un agrandissement correspondant au doublet 013/103 de la forme orthorhombique apparaissant dans la figure 4.

### EXEMPLE 1

On pèse avec précision les précurseurs élémentaires suivants dont la pureté est supérieure à 99%.
- 13,55g de Y₂0₃
- 41,44g de BaCO₃
- 24,66g de CuO.

On ajoute 1% de "Lubromine" (marque PROTEX), additif anticolmatant pour broyage à sec. On broie pendant deux heures à sec dans un broyeur planétaire jusqu'à l'obtention d'un diamètre moyen de 1 µm.

Par compression isostatique à 2000 bars de ce mélange poudreux on réalise des tubes 1 de diamètre intérieur 8 mm, de diamètre extérieur 10 mm et de longueur 70 mm.

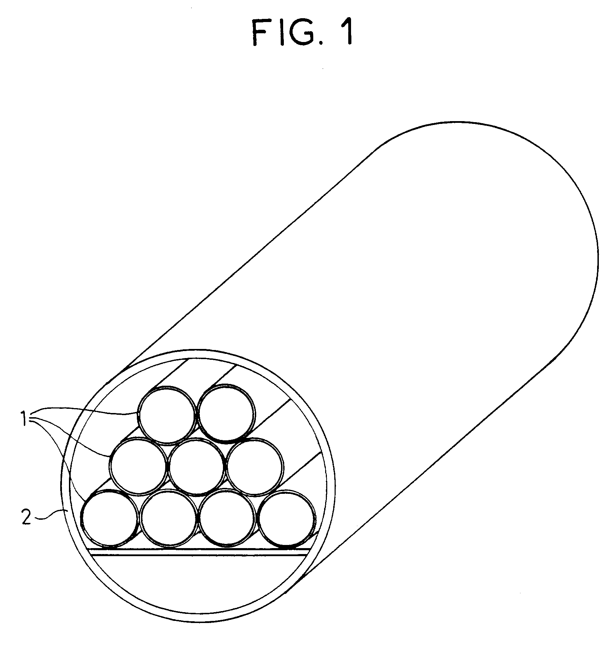

Ces tubes 1 sont empilés en pyramide selon la figure 1 et traités thermiquement dans un four tubulaire (schématisé par un cylindre 2) selon le processus suivant:

| | |
|---|---|
| - montée à 120°C/h jusqu'à | 800°C |
| - montée à 30°C/h jusqu'à | 900°C |
| - premier palier de 15 heures à | 900°C |
| - montée à 30°C/h jusqu'à | 940°C |
| - second palier de 30 heures à | 940°C |
| - descente à 60°C/h jusqu'à | 600°C |
| - descente à 30°C/h jusqu'à | 450°C |
| - troisième palier de 15 heures à | 450°C |
| - descente à 60°C/h jusqu'à | 250°C |
| - descente à 120°C/h jusqu'à | 25°C. |

Les six premières étapes sont effectuées sous un débit gazeux de 15 litres/heure d'oxygène et de 60 litres/heure d'azote, soit 20% d'oxygène; le troisième palier à 450°C et les étapes suivantes sont effectués sous oxygène pur.

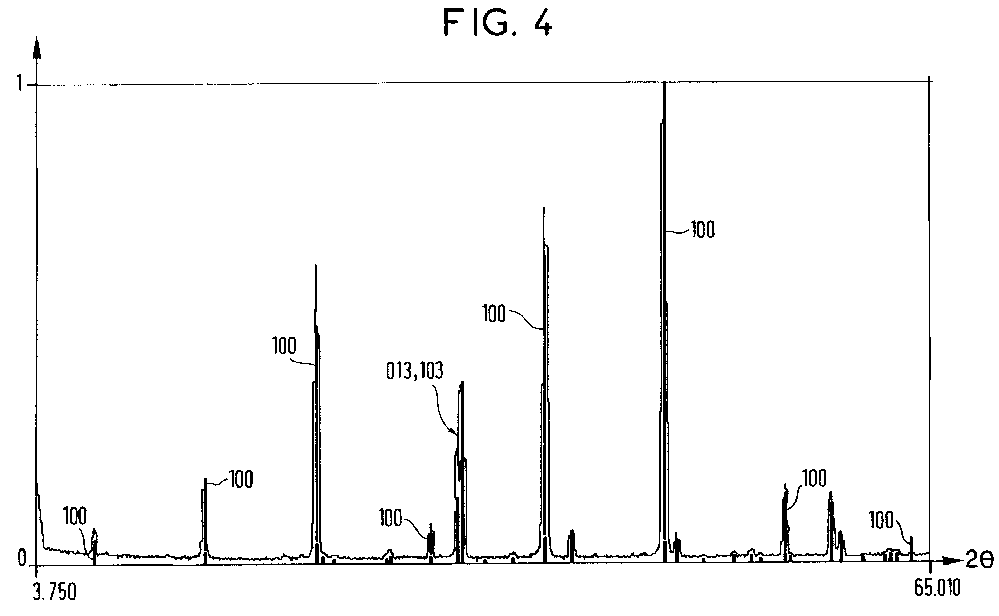

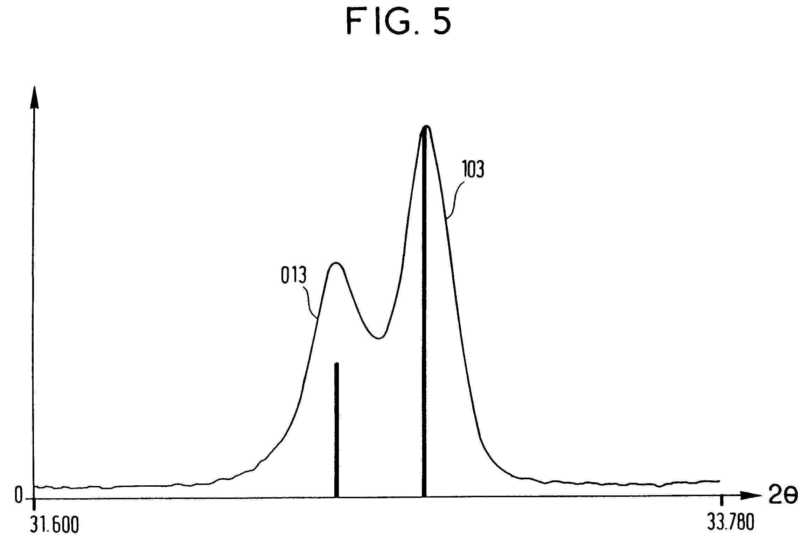

Les tubes 1 sont alors réduits par un broyage de une heure dans un broyeur planétaire en une poudre caractérisée par diffraction X; le diagramme apparaît dans les figures 4 et 5 avec en abscisses l'angle de diffraction 2θ. On constate que la poudre obtenue est constituée de phase orthorhombique pure dépourvue des phases parasites habituelles Y₂BaCu0₅, BaCu0₂ et CuO. Le doublet caractéristique 013/103 apparaît très clairement dans la figure 5.

La poudre est bien cristallisée sous forme de plaquettes au point que, lors de la préparation de l'échantillon pour le test de diffraction X, ces plaquettes se disposent parallèlement au support, l'axe C lui étant perpendiculaire, ce qui a pour effet de renforcer les raies OOl repérées 100 sur la figure 4.

La poudre selon l'invention, grâce à son aptitude au fluage relativement élevée pour un produit minéral, est bien adaptée à la réalisation de conducteur multifilamentaire par la méthode dite "poudre dans tube". Cette technique consiste à soumettre à des cycles d'étirage-recuit un tube métallique rempli de poudre; après diminution suffisante de diamètre, un faisceau des monobrins ainsi obtenus est introduit dans un nouveau tube et le processus est recommencé; on arrive ainsi à des brins élémentaires de 10 µm environ avec des parois de 1 µm puisque la poudre est suffisamment fluable; dans le cas contraire les grains de poudre perceraient la paroi et il arriverait même que les filaments se rompent à l'intérieur de leur matrice.

### EXEMPLE 2

Il est identique à l'exemple 1, sauf en ce qui concerne la poudre de départ qui est un produit commercial obtenu par calcination d'un aérosol de nitrates d'yttrium, de baryum et de calcium en solution dans l'eau; il est constitué essentiellement de phase Y123 quadratique et de Y₂BaCu0₅, BaCuO₂ et Cu0, mais dont la stoechiométrie globale est Y₁Ba₂Cu₃ avec une précision à moins de 1%. Chaque espèce de cette composition est sous la forme de grains de 1 µm environ, et donc très réactive.

Après un traitement analogue à celui de l'exemple 1, le produit final est d'une qualité légèrement inférieure au niveau de l'orthorhombicité et de la cristallisation; quelques agglomérats subsistent à côté des gros grains bien formés. Il convient donc d'effectuer un tamisage à 50 µm avant d'utiliser ce type de poudre. On obtient alors des résultats équivalents à ceux de l'exemple 1.

### EXEMPLE 3

Il est identique à l'exemple 1, sauf en ce qui concerne la forme des pièces intermédiaires qui définissent une structure en nid d'abeille 10 dont l'épaisseur des parois est inférieure à 2 mm.

### EXEMPLE 4

Il est identique à l'exemple 1, sauf en ce qui concerne la forme des pièces intermédiaires qui sont des plaques ou des pastilles 11 d'épaisseur inférieure à 2 mm, empilées les unes sur les autres et séparées par des cales 12.

Bien entendu l'invention n'est pas limitée aux modes de réalisation qui viennent d'être décrits. On pourra, sans sortir du cadre de l'invention tel que défini par les revendications, modifier les paramètres dans le cadre des fourchettes indiquées et remplacer tout moyen par un moyen équivalent.

## Revendications

1. Procédé de préparation d'une poudre d'YBaCuO (phase 123) en vue d'une mise en forme par étirage-laminage, procédé selon lequel:
- on prépare un mélange réactionnel poudreux de précurseurs de pureté supérieure à 99% et dont la stoechiométrie est exacte à moins de 1%,
- on agglomère ce mélange réactionnel poudreux pour en faire des pièces intermédiaires (1, 10, 11) d'épaisseur inférieure à deux millimètres que l'on introduit dans un four en limitant au maximum leur contact avec un support,
- on effectue un traitement thermique comportant au moins les étapes suivantes:
. un premier palier de durée comprise entre 10 et 30 heures à une température T₁ comprise entre 890°C et 910°C sous une atmosphère à 20% d'oxygène, correspondant à la synthèse de la phase Y123 quadratique,
. un second palier de durée comprise entre 20 et 100 heures à une température T₂ comprise entre 920°C et 960°C sous une atmosphère à 20% d'oxygène, correspondant à la recristallisation de la phase quadratique Y123,
. un troisième palier de durée comprise entre 10 et 50 heures à une température T₃ comprise entre 500°C et 300°C sous oxygène pur, correspondant à la transformation de la phase Y123 quadratique en phase Y123 orthorhombique,
- on effectue un broyage a sec jusqu'à obtenir des grains de diamètre moyen inférieur à 50 µm formant ladite poudre.

2. Procédé de préparation selon la revendication 1, caractérisé par le fait que ledit mélange réactionnel de précurseurs est un mélange poudreux de précurseurs élémentaires Y₂O₃, BaCO₃, CuO.

3. Procédé de préparation selon la revendication 1, caractérisé par le fait que ledit mélange réactionnel de précurseurs est obtenu par coprécipitation, puis filtré et séché.

4. Procédé de préparation selon la revendication 1, caractérisé par le fait que ledit mélange réactionnel est un produit obtenu par calcination d'un aérosol de nitrates d'yttrium, de baryum et de cuivre en solution dans l'eau.

5. Procédé de préparation selon l'une des revendications 1 à 4, caractérisé par le fait que lesdites pièces intermédiaires sont des tubes (1) empilés en pyramide.

6. Procédé de préparation selon l'une des revendications 1 à 4, caractérisé par le fait que lesdites pièces intermédiaires sont des plaques ou des pastilles (11) empilées les unes sur les autres et séparées par des cales (12).

7. Procédé de préparation selon l'une des revendications 1 à 4, caractérisé par le fait que lesdites pièces intermédiaires définissent une structure alvéolaire (10) en nid d'abeille.

8. Procédé de préparation selon l'une des revendications précédentes, caractérisé par le fait que ledit traitement thermique est mené de la manière suivante:
- montée rapide jusqu'à 800°C
- montée lente jusqu'à T₁
- premier palier de 10 à 3O heures à T₁
- montée lente jusqu'à T₂
- second palier de 20 à 100 heures à T₂ (d'autant plus long que T₂ est plus basse)
- descente moyenne jusqu'à 600°C
- descente lente jusqu'à T₃
- troisième palier de 10 à 50 heures à T₃ (d'autant plus long que l'épaisseur desdites pièces intermédiaires est plus grande)
- descente moyenne jusqu'à 250°C
- descente rapide jusqu'à 25°C,
procédé dans lequel :
- montée ou descente rapide signifie 120 à 60°C/heure,
- montée ou descente moyenne signifie 60 à 40°C/heure,
- montée ou descente lente signifie 40 à 20°C/heure.

## Claims

1. A method of preparing a powder of YBaCuO [phase 123] suitable for forming by drawing-lamination, which method comprises:
• preparing a powdered reactive mixture of precursors of purity greater than 99% and with stoichiometry accurate to less than 1%,
• binding this powdered reactive mixture to form intermediate pieces (1,10,11) less than two millimeters in thickness which are placed in an oven so that their contact with a support is as small as possible,
• performing heat treatment comprising at least the following stages:
a first dwell of duration in the range 10 hours to 30 hours at a temperature T₁ in the range 890°C to 910°C in an atmosphere of 20% oxygen, corresponding to synthesis of the quadratic Y123 phase,
a second dwell of duration in the range 20 hours to 100 hours at a temperature T₂ in the range 920°C to 960°C in an atmosphere of 20% oxygen, corresponding to re-crystallization of the quadratic Y123 phase, and
a third dwell of duration in the range 10 hours to 50 hours at a temperature T₃ in the range 500°C to 300°C in a pure oxygen atmosphere, corresponding to transformation of the quadratic Y123 phase into the orthorhombic Y123 phase, and
• dry grinding to obtain grains of said powder with an average diameter less than 50 µm.

2. A method of preparation according to claim 1, characterized in that said reactive mixture of precursors is a powdered mixture of individual precursors Y₂O₃, BaCO₃, CuO.

3. A method of preparation according to claim 1, characterized in that said reactive mixture of precursors is obtained by coprecipitation, followed by filtering and drying.

4. A method of preparation according to claim 1, characterized in that said reactive mixture is a product obtained by calcination of an aerosol of nitrates of yttrium, barium and copper in solution in water.

5. A method of preparation according to any of claims 1 to 4, characterized in that said intermediate pieces are tubes (1) stacked in a pyramid.

6. A method of preparation according to any of claims 1 to 4, characterized in that said intermediate pieces are sheets or pellets (11) stacked on top of one another, and separated by packing pieces(12).

7. A method of preparation according to any of claims 1 to 4, characterized in that said intermediate pieces define a cellular structure (10) similar to a honeycomb.

8. A method of preparation according to any of the preceding claims, characterized in that said heat treatment is carried out in the following manner:
rapid rise up to 800°C
slow rise up to T₁
first dwell of 10 to 30 hours at T₁
slow rise up to T₂
second dwell of 20 to 100 hours at T₂ (longer if T₂ is lower)
medium fall down to 600°C
slow fall down to T₃
third dwell of 10 to 50 hours at T₃ (longer if the thickness of said intermediate pieces is greater)
medium fall down to 250°C
rapid fall down to 25°C,
in which method:
rapid rise or fall means : 120 to 60°C/hour
medium rise or fall means: 60 to 40°C/hour
slow rise or fall means : 40 to 20°C/hour.

## Patentansprüche

1. Verfahren zur Herstellung eines Pulvers von YBaCuO (Phase 123), das später durch Ziehen und Walzen ausgeformt werden soll, wobei das Verfahren folgende Schritte enthält:
- man bereitet eine pulverförmige Reaktionsmischung von Vorläufern einer Reinheit größer als 99% vor, deren Stöchiometrie bis auf höchstens 1% genau stimmt,
- man agglomeriert diese pulverförmige Reaktionsmischung und stellt daraus Zwischenproduktteile (1, 10, 11) einer Dicke von weniger als 2 mm her, die dann in einen Ofen gebracht werden, wobei man ihren Kontakt mit einem Träger möglichst beschränkt,
- man unterwirft die Teile einer Wärmebehandlung, die mindestens die folgenden Phasen aufweist:
. eine erste Stufe einer Dauer zwischen 10 und 30 Stunden bei einer Temperatur T₁ zwischen 890 und 910°C in einer Atmosphäre mit 20% Sauerstoff, entsprechend der Synthese der quadratischen Y123-Phase,
. eine zweite Stufe einer Dauer zwischen 20 und 100 Stunden bei einer Temperatur T₂ zwischen 920 und 960°C in einer Atmosphäre mit 20% Sauerstoff, entsprechend der Rekristallisierung der quadratischen Phase Y123,
. eine dritte Stufe einer Dauer zwischen 10 und 50 Stunden bei einer Temperatur T₃ zwischen 500 und 300°C in reinem Sauerstoff, entsprechend der Umwandlung der quadratischen Phase Y123 in die orthorombische Phase Y123,
- das Material wird trocken gemahlen, bis die das Pulver bildenden Körner einen mittleren Durchmesser unterhalb 50 µm besitzen.

2. Verfahren nach Anspruch 1, dadurch gekennzeichnet, daß die Reaktionsmischung der Vorläufer eine Pulvermischung von elementaren Vorläufern Y₂O₃, BaCo₃, CuO ist.

3. Verfahren nach Anspruch 1, dadurch gekennzeichnet, daß die Reaktionsmischung von Vorläufern durch gemeinsame Ausfällung und dann durch Filtrierung und Trocknung erhalten wird.

4. Verfahren nach Anspruch 1, dadurch gekennzeichnet, daß die Reaktionsmischung ein Produkt ist, das durch Verbrennen eines Aerosols von Nitraten von Yttrium, Barium und Kupfer gelöst in Wasser erhalten wird.

5. Verfahren nach einem der Ansprüche 1 bis 4, dadurch gekennzeichnet, daß die Zwischenproduktteile in Pyramiden gestapelte Rohre (1) sind.

6. Verfahren nach einem der Ansprüche 1 bis 4, dadurch gekennzeichnet, daß die Zwischenproduktteile Platten oder Scheiben (11) sind, die übereinandergestapelt und durch Abstandshalter (12) voneinander getrennt sind.

7. Verfahren nach einem der Ansprüche 1 bis 4, dadurch gekennzeichnet, daß die Zwischenproduktteile eine wabenförmige Struktur (10) definieren.

8. Verfahren nach einem der vorhergehenden Ansprüche, dadurch gekennzeichnet, daß die Wärmebehandlung folgendermaßen abläuft:
- schnelle Erwärmung bis 800°C,
- langsame Erwärmung bis zur Temperatur T₁,
- erste Stufe von 10 bis 30 Stunden bei T₁,
- langsame Erwärmung bis zur Temperatur T₂,
- zweite Stufe von 20 bis 100 Stunden bei T₂ (umso länger, je niedriger T₂ ist),
- mittelschnelle Abkühlung bis auf 600°C,
- langsame Abkühlung bis auf T₃,
- dritte Stufe von 10 bis 50 Stunden bei T₃ (umso länger, je dicker die Zwischenproduktteile sind,
- mittelschnelle Abkühlung bis auf 250°C,
- schnelle Abkühlung bis auf 25°C,
wobei
- eine rasche Erwärmung oder Abkühlung 120 bis 60°/h bedeutet,
- eine mittelschnelle Erwärmung oder Abkühlung 60 bis 40°/h bedeutet,
- eine langsame Erwärmung oder Abkühlung 40 bis 20°/h bedeutet.
